**Europäisches Patentamt**

**European Patent Office**

**Office européen des brevets**

(19)

(11) Veröffentlichungsnummer: **0 018 556**
**B1**

(12) # EUROPÄISCHE PATENTSCHRIFT

(45) Veröffentlichungstag der Patentschrift:
**08.08.84**

(51) Int. Cl.³: **H 01 L 21/306, C 25 F 3/12**

(21) Anmeldenummer: **80102081.9**

(22) Anmeldetag: **18.04.80**

(54) **Anordnung und Verfahren zum selektiven, elektrochemischen Ätzen.**

(30) Priorität: 02.05.79 DE 2917654
22.12.79 DE 2951938

(43) Veröffentlichungstag der Anmeldung:
**12.11.80 Patentblatt 80/23**

(45) Bekanntmachung des Hinweises auf die Patenterteilung:
**08.08.84 Patentblatt 84/32**

(84) Benannte Vertragsstaaten:
**DE FR GB**

(56) Entgegenhaltungen:
AT - B - 300 038
CH - A - 407 333
DD - A - 57 390
DE - B - 1 206 090
DE - B - 1 252 322
FR - A - 1 066 306
FR - A - 1 177 006
GB - A - 1 448 048
US - A - 3 000 797
US - A - 3 196 094
US - A - 3 749 653

(73) Patentinhaber: **International Business Machines Corporation, Old Orchard Road, Armonk, N.Y. 10504 (US)**

(72) Erfinder: **Bühne, Joachim, Blossenbergstrasse 42, D-7251 Helmsheim (DE)**
Erfinder: **Frosch, Albert, Geranienstrasse 22, D-7033 Herrenberg 1 (DE)**
Erfinder: **Schäfer, Rolf, Dr., Ritterstrasse 25, D-7031 Gärtringen-Rohrau (DE)**
Erfinder: **Stoffel, Axel, Dr., Berliner Strasse 44, D-7743 Furtwangen (DE)**

(74) Vertreter: **Oechssler, Dietrich Dr. rer. nat., Schönaicher Strasse 220, D-7030 Böblingen (DE)**

**Beschreibung**

Die Erfindung betrifft eine im Oberbegriff des Anspruchs 10 definierte Anordnung und ein im Oberbegriff des Anspruchs 1 definiertes Verfahren.

Ein derartiges Verfahren und eine derartige Anordnung sind aus der DE-B-1 206 090 bekannt.

Es sind verschiedene Methoden bekannt, um Materialien selektiv, elektrochemisch zu ätzen. Im allgemeinen wird bei diesen Verfahren der Körper, dessen Oberfläche geätzt werden soll, zur Anode der Ätzanordnung gemacht und mit dem Elektrolyten, in welche die Kathode eintaucht, benetzt. Eine selektive Ätzung einer Oberfläche läßt sich beispielsweise so erreichen, daß dafür gesorgt wird, daß der Elektrolyt nur die zu ätzenden Bereiche der Oberfläche kontaktiert. Dies wird entweder dadurch erreicht, daß die Bereiche der Oberfläche, welche nicht geätzt werden sollen, mit einem geeigneten Maskenmaterial bedeckt werden, oder daß dafür gesorgt wird, daß der Elektrolyt nur die zu ätzenden Oberflächenbereiche bedeckt. Ein Verfahren, welches auf dem zuletzt genannten Prinzip beruht, ist in der deutschen Offenlegungsschrift 2 707 372 und in dem IBM Technical Disclosure Bulletin, Band 20, Nr. 7, Dezember 1977, Seite 2912 beschrieben. Bei einer anderen Gruppe von Verfahren wird über eine Variation der Stromdichte entlang der zu ätzenden Oberfläche erreicht, daß lokal sehr unterschiedliche Ätzgeschwindigkeiten auftreten, wodurch es unter anderem möglich ist, Vertiefungen mit einem komplexen Profil in die Oberfläche eines Körpers zu ätzen. Lokal unterschiedliche Stromdichten können beispielsweise erzeugt werden, indem die der Anode zugewandte Seite der Kathode mit einem Profil versehen wird, welches dem Negativ des Oberflächenprofils entspricht, welches in der zu ätzende Oberfläche erzeugt werden soll. Ein ausführlicher Artikel über dieses Verfahren ist in Scientific American, Dezember 1974, Seite 30 erschienen. Mit den Kathoden der genannten Art lassen sich auch Vertiefungen erzeugen, deren Boden parallel und deren Wände im wesentlichen senkrecht zur ursprünglichen Oberfläche verlaufen, oder deren Boden eine zur ursprünglichen Oberfläche geneigte ebene Fläche bildet. Solche zur ursprünglichen Fläche geneigte Ebenen können auch mit einem Verfahren erzeugt werden, welches im IBM Technical Disclosure Bulletin, Band 13, Nr. 3, August 1970, Seite 726 beschrieben ist und bei dem die für die Bildung der geneigten Ebene notwendige Änderung der Ätzgeschwindigkeit bzw. der Stromdichte dadurch erreicht wird, daß die als Platte ausgebildete Kathode mit der zu ätzenden Fläche einen spitzen Winkel bildet. Ein weiteres Verfahren zum Ätzen von gegenüber der ursprünglichen Oberfläche geneigten Flächen ist aus dem IBM Technical Disclosure Bulletin, Band 18, Nr. 4, September 1975, Seite 1223 bekannt, bei dem die zu ätzende Fläche während des Ätzens mit definierter Geschwindigkeit aus dem Elektrolyt herausgezogen wird, so daß parallel zur Ziehrichtung die Dauer des Ätzvorgangs, dem das Material unterworfen war, und damit auch die Menge des abgetragenen Materials einen Gradienten aufweisen.

Die genannten Verfahren zum Ätzen von gegenüber den ursprünglichen Oberflächen geneigten Flächen haben den Nachteil, daß es mit ihnen sehr schwierig ist, einen Neigungswinkel genau und reproduzierbar zu erzeugen oder sehr kleine geneigte Flächen definiert und reproduzierbar herzustellen. Dafür besteht aber, beispielsweise in der Halbleitertechnik ein Bedürfnis. Geneigte Flächen mit einem genau definierten Neigungswinkel werden bei der Prozeßkontrolle nach Verfahrensschritten, bei denen das Halbleitermaterial dotiert worden ist, benötigt. Mittels Diffusion oder Ionenimplantation dotierte P- und N-leitende Gebiete in Halbleiterplättchen werden durch ihre Eindringtiefe sowie die Verteilung der Dotierungsatome (Dotierungsprofil) charakterisiert. Unter der Eindringtiefe versteht man dabei den Abstand des P/N-Übergangs von der Halbleiteroberfläche und unter dem Dotierungsprofil versteht man die Dotierungstoffkonzentration aufgetragen über der Entfernung von der Halbleiteroberfläche. Da die Eindringtiefe und die interessierenden Entfernungen von der Halbleiteroberfläche im μm-Bereich liegen, ist es unmittelbar einleuchtend, daß es sehr schwierig sein dürfte, eine genaue Messung der Eindringtiefe oder gar der Änderung der Dotierungskonzentration mit der Entfernung von der Halbleiteroberfläche an einem Schnitt durch den Halbleiter senkrecht zur Halbleiteroberfläche vorzunehmen. Zur Durchführung dieser Messungen wird deshalb üblicherweise zunächst ein Schrägschliff durch das dotierte Material hergestellt. Dabei werden die Eindringtiefe und die Entfernungen zur Halbleiteroberfläche um den Faktor $\frac{1}{\sin \alpha}$ gedehnt, wobei der Winkel $\alpha$ der spitze Winkel ist, welchen die abgeschliffene Fläche mit der Halbleiteroberfläche bildet. An der geschliffenen Fläche kann dann unter Berücksichtigung des Winkels $\alpha$ durch eine Anfärbemethode die Eindringtiefe und durch eine punktweise Messung des Ausbreitungswiderstandes entlang der Fallinie der angeschliffenen Fläche das Dotierungsprofil ermittelt werden. Es leuchtet ein, daß diese Messungen um so genauer gemacht werden werden können, je kleiner der Winkel $\alpha$ ist. Es leuchtet außerdem ein, daß, wenn die Eindringtiefe verringert wird, d. h. wenn, was für die zunehmende Miniaturisierung in der Halbleitertechnik typisch ist, zu flacheren dotieren Bereichen übergegangen wird, die gleiche Genauigkeit der Messung wie bei dickeren Diffusionsgebieten nur dann gewährleistet ist, wenn der Winkel $\alpha$ entsprechend kleiner gemacht wird. Man ist heute in der Lage, Winkel $\alpha$ von 8' herzustellen Das Problem bei diesen sehr flachen Winkeln ist jedoch, daß Rundungen an der Kante zwischen der Halbleiteroberfläche und der angeschliffenen Fläche auftreten, die die Messung der Eindringtiefe und des Dotierungsprofils verfälschen. Es ist nämlich für die Genauigkeit der Messung nicht nur ausreichend, daß man einen hinreichend kleinen Winkel $\alpha$ erzeugen kann, vielmehr muß, da der Sinus des Winkels in die Messung eingeht der Winkel genau definiert und reproduzierbar erzeugt werden können. Beim Anschleifen ist es außerdem sehr schwierig, Oberflächen mit gleichbleibend guter Qualität herzustellen. Schwankungen in der Oberflächenqualität beeinträchtigen aber auch die Messung der Eindringtiefe und des Dotierungsprofils. Wegen der genannten Nachteilen der Anschleiftechnik wäre es vorteilhaft, zum Herstellen der geneigten Flächen ein Ätzverfahren zu verwenden. Jedoch sind die obengenannten Verfahren — wie schon gesagt — dafür zu grob.

In letzter Zeit finden gegenüber der Halbleiteroberfläche geneigte Flächen in der Form von V-förmigen Kerben Eingang in die Halbleitertechnik. In diesen V-förmigen Kerben lassen sich beispielsweise Feldeffekttransistoren so unterbringen, daß sie weniger Platz beanspruchen als wenn sie parallel zur Halbleiteroberfläche, d. h., zur Schaltungsebene angeordnet sind. Bei dem zunehmenden Trend zu immer höherer Packungsdichte bei den integrierten Schaltungen sind solche platzsparenden Verfahren von großem Interesse. Allerdings ist es so, daß der Winkel zwischen den beiden Schenkeln des V für eine bestimmte Kristallorientierung festgelegt ist und daß, was mit diesem festgelegten Winkel zusammenhängt, die maximale Tiefe der Kerbe und die maximale Schenkellänge der Kerbe durch die Dimensionierung der Kerbe an der Halbleiteroberfläche festgelegt ist. Wäre es möglich, den Winkel zwischen den Schenkeln zu variieren, würde die Flexibilität bei der Schaltkreisauslegung wesentlich erhöht werden. Mit den obengenannten elektrochemischen Ätzmethoden könnten zwar sehr unterschiedliche Winkel erzeugt werden, jedoch sind diese Verfahren, abgesehen von der Schwierigkeit, genau definierte Winkel reproduzierbar herzustellen, deshalb für den genannten Zweck unbrauchbar, weil die genannten V-förmigen Kerben Abmessungen im μm-Bereich haben.

Es ist die Aufgabe der Erfindung, eine Vorrichtung und ein Verfahren anzugeben, um insbesondere Halbleiteroberflächen einfach und leicht steuerbar in der Weise zu ätzen, daß eine ebene Fläche entsteht, welche kleine Abmessungen haben kann, mit der ursprünglichen Oberfläche einen genau festgelegten und reproduzierbaren Neigungswinkel zwischen 0 und nahezu 90° bildet und eine gute Oberflächenqualität aufweist.

Diese Aufgabe wird mit einer Vorrichtung der eingangs genannten Art mit den Merkmalen des kennzeichnenden Teils des Anspruchs 10 und mit einem Verfahren der eingangs genannten Art mit den Merkmalen des kennzeichnenden Teils des Anspruchs 1 gelöst.

Aus der GB-A-1 448 048 ist es bekannt, ein Werkstück während des Ätzens mit Licht zu bestrahlen, um anhand der Veränderung des Reflexionssignals die erfolgte Abätzung einer dielektrischen Schicht festzustellen.

Die erfindungsgemäße Anordnung in Verbindung mit dem erfindungsgemäßen Verfahren ist vielfältig einsetzbar. Auch dann, wenn — wie es beispielsweise in der Halbleitertechnik ganz allgemein der Fall ist — die Abmessungen der zu ätzenden Flächen sehr klein sind, ist es möglich, reproduzierbar Vertiefungen zu ätzen, welche sehr genau festgelegte Formen und Abmessungen haben und bei denen die Oberflächen eine sehr gute Qualität haben. Das eigentliche Ätzen ist mit der erfindungsgemäßen Anordnung sehr einfach. Die vorbereitenden Arbeiten, wie beispielsweise das Aufbringen von Leiterzügen bzw. Kontaktbereichen ist nicht ganz so einfach, jedoch ist die Komplexität des gesamten Verfahrens auf keinen Fall größer als bei den bekannten Verfahren, mit denen vergleichbare Ergebnisse erzielt werden. Darüber hinaus hat, worauf weiter unten eingegangen werden wird, die Erfindung gegenüber diesen bekannten Verfahren beachtliche Vorteile.

Es ist vorteilhaft, wenn eines der Potentiale am Werkstück auf demselben Niveau wie das Kathodenpotential liegt. Man erhält dann beim Ätzen geneigte Flächen, welche ohne eine dazwischenliegende Stufe direkt an der Oberfläche, von der beim Ätzen ausgegangen wurde, beginnt.

Es ist günstig, wenn der zu ätzende Bereich auf dem Werkstück von zwei einander gegenüberliegenden gut leitenden Bereichen begrenzt ist. Ebene geneigte Flächen mit einem über die ganze Fläche konstanten Neigungswinkel gegenüber der Fläche, von der ausgegangen wird, erhält man dabei dann, wenn die von den gut leitenden Bereichen gebildeten Begrenzungen zueinander parallel sind.

Es ist vorteilhaft, wenn die erfindungsgemäße Anordnung eine Lampe mit einem hohen Lichtanteil im nahen infraroten Bereich zur Bestrahlung der zu ätzenden Fläche aufweist. Eine solche Bestrahlung wirkt sich beispielsweise beim Ätzen von N-dotiertem — insbesondere von schwach N-dotiertem — Silicium vorteilhaft aus. Ohne diese Bestrahlung fehlt dem N-dotiertem Silicium die Löcher-Leitfähigkeit, was zur Folge hat, daß beim Ätzen von N-dotiertem Silicium eine inhomogene Abtragung erfolgt bzw. ein poröses Material entsteht. Außerdem lassen sich durch die Bestrahlung die Geschwindigkeiten, mit welchen P- und N-dotiertes Silicium geätzt werden, beeinflussen.

Mit der erfindungsgemäßen Anordnung können u. a. auch dieselben Strukturen, beispielsweise in Halbleiterplättchen, erzeugt werden, wie mit der reaktiven Ionenätzmethode. Jedoch ist die erfindungsgemäße Anordnung apparativ weit weniger aufwendig.

Das erfindungsgemäße Verfahren eröffnet in vorteilhafter Weise Alternativen zu bekannten Verfahren. Solche bekannten Verfahren sind beispielsweise das Erzeugen von Schrägschliffen an mittels Diffusion oder Ionenimplantation dotierten Halbleiterplättchen, um anschließend die Eindringtiefe und das Dotierungsprofil zu messen, und das Herstellen von V-förmigen Kerben in Halbleiterplättchen, welches dazu dient, um die Dichte von Halbleiterbauteilen in integrierten Schaltungen zu erhöhen.

Darüber hinaus hat das erfindungsgemäßen Verfahren gegenüber den bekannten Verfahren beachtliche Vorteile: Die geätzten geneigten Flächen haben eine bessere Qualität, was die Konstanz des Neigungswinkels anbetrifft, als die angeschliffenen Flächen. Die geneigten, mittels des erfindungsgemäßen Verfahrens hergestellten, Flächen können aber vor allem viel kleinere Abmessungen haben, als die Flächen, welche durch Anschleifen erzeugt werden. Dadurch ist es möglich, beispielsweise die obenerwähnten Messungen der Eindringtiefe und des Dotierungsprofils direkt an Produktplättchen, d. h., an solchen Plättchen, in welchen integrierte Schaltungen erzeugt werden, vorzunehmen. Solche geätzten Flächen können z. B. in dem Gebiet der Halbleiterplättchen erzeugt werden, welche beim Sägen wegfallen, wenn die Halbleiterplättchen in Chips zerlegt werden. Die beschriebene Messung an den Produktplättchen hat nicht nur den Vorteil, daß auf die üblicherweise mit den Produktplättchen mitprozessierten Testplättchen verzichtet werden kann, vielmehr erhält man durch die Messung am Produktplättchen genauere Aufschlüsse über die Prozeßbedingungen, denen die entstehenden Halbleiterschaltungen ausgesetzt sind, als wenn man solche Messungen an Testplättchen vornimmt. Das erfindungsgemäße Verfahren ist auch flexibler als die bekannten Verfahren. Beispielsweise ist bei der bekannten V-Kerben-Technik der Winkel zwischen den Schenkeln des V durch die Kristallorientierung der Halbleiterplättchenoberfläche genau festgelegt. Bei dem erfindungsgemäßen Verfahren hingegen kann dieser Winkel in weiten Grenzen variiert werden.

Es ist vorteilhaft, wenn bei dem erfindungsgemäßen Verfahren eine (über die geätzte Fläche) durchschnittliche Stromdichte von $< 200$ mA/cm$^2$ eingestellt wird. Oberhalb dieser Stromdichte wird es schwierig, den Ätzvorgang zu kontrollieren.

Da bei einer Änderung der Bestrahlungsstärke — anders als bei einer Änderung der anderen Parameter — die Abtragungsgeschwindigkeiten von P- und N-dotiertem Silicium unterschiedlich beeinflußt werden, ist es über eine Änderung der Bestrahlungsstärke möglich, das Verhältnis der Abtragungsgeschwindigkeit von P-dotiertem Silicium zu der von N-dotiertem Silicium definiert einzustellen. Da die Bestrahlungsstärke, mit welcher die zu ätzende Fläche bestrahlt wird, von der Lampenleistung, dem Abstand der Lampe von der zu ätzenden Fläche und von der Schichtdicke des Elektrolyten zwischen der Lampe und der zu ätzenden Fläche abhängt, ist es einfach eine gewünschte Bestrahlungsstärke einzustellen. Bei der Einstellung einer bestimmten Bestrahlungsstärke geht man am besten so vor, daß man den Abstand zwischen Lampe und zu ätzende Fläche und die Schichtdicke konstant läßt und dann einen Wert der Lampenleistung einstellt, welcher aus einer zuvor erstellten Kalibrierkurve entnommen wird, in welcher Bestrahlungsstärken gegen Lampenleistungen aufgetragen sind. Zum Bestrahlen empfiehlt sich beispielsweise eine Halogenlampe mit Goldreflektor, welche von der Firma Osram unter der Typennummer 64635 angeboten wird.

Es ist vorteilhaft, wenn bei Bestrahlungsstärken im Bereich zwischen $>$ etwa 25 und $<$ etwa 150 mW/cm$^2$ geätzt wird, wobei sich diese Angabe auf den Wellenlängenbereich von 720 bis 800 nm bezieht, wobei eine Lampe verwendet wird, welche mindestens im Wellenlängenbereich von 700 bis 1300 nm kontinuierlich emittiert. Die entsprechenden Verteilungstemperaturen der Lampe liegen dabei zwischen etwa 2550 und 3400 °K und die Schichtdicke des Elektrolyten beträgt 25 mm. Auch alle folgenden Angaben der Bestrahlungsstärke beziehen sich auf den genannten Wellenlängenbereich. Bei Bestrahlungsstärken $<$ ungefähr 25 mW/cm$^2$ erhält man beim Ätzen von N-dotiertem Silicium keinen homogenen Abtrag mehr, vielmehr weist die geätzte Fläche dann Bereiche, welche praktisch nicht angegriffen worden sind, neben sehr tiefen Gräben auf. Bei Bestrahlungsstärken $>$ ungefähr 150 mW/cm$^2$ ist das Ätzen von N-dotiertem Silicium nicht mehr gut reproduzierbar.

Besonders vorteilhaft ist es, wenn bei einer Bestrahlungsstärke von ungefähr 70 mW/cm$^2$ gearbeitet wird. Bei dieser Bestrahlungsstärke ist der Abtrag nicht nur besonders reproduzierbar ($< \pm 5\%$), sondern es werden auch P- und N-dotiertes Silicium mit gleicher Geschwindigkeit abgetragen. Ein Ätzgeschwindigkeitenverhältnis von 1 : 1 ist nicht bei allen Anwendungen erforderlich (oft genügt es, wenn das Verhältnis ausreichend genau definiert ist), jedoch werden fast alle Ätzanwendungen, bei denen es auf definierte Abtragungen ankommt, dadurch wesentlich vereinfacht. Ein Ätzgeschwindigkeitenverhältnis von 1 : 1 ist erforderlich, wenn beispielsweise bei der Herstellung von integrierten Schaltungen in Siliciummaterial, welches nebeneinander P- und N-dotierte Bereiche aufweist, Isolationswannen geätzt werden sollen, welche alle gleich tief sind und deren Böden vollständig flach und parallel zur Oberfläche, von der ausgegangen worden ist, sind. Ein anderer Fall, in welchem es unbedingt erforderlich ist, daß P- und N-dotiertes Silicium gleich schnell geätzt werden, ist der, in welchem in ein Halbleitersubstrat, welches an seiner Oberfläche mehrere beispielsweise mittels Epitaxie aufgebrachte Schichten unterschiedlichen Leitungstyps aufweist eine geneigte, die Schichten schneidende Fläche, welche in sich eben und einheitlich steil ist, geätzt werden soll.

Weitere vorteilhafte Ausführungen der erfindungsgemäßen Anordnungen und des erfindungsgemäßen Verfahrens sind den Unteransprüchen zu entnehmen.

Die Erfindung wird anhand von durch Zeichnungen erläuterten Ausführungsbeispielen beschrieben. Es zeigen:

Fig. 1 in schematischer Darstellung eine im Querschnitt gezeigte Ausführungsform der erfindungsgemäßen Anordnung (bei der die Lampe weggelassen ist),

Fig. 2A in Aufsicht eine weitere auf einem Siliciumplättchen aufgebrachte Ausführungsform der erfindungsgemäßen Anordnung,

Fig. 2B einen Schnitt durch die in der Fig. 2A gezeigte Anordnung und das Siliciumplättchen, welches N- und P-dotierte Schichten aufweist, entlang der Linie A-A nach dem Abschluß des Ätzens gemäß dem erfindungsgemäßen Verfahren,

Fig. 3 ein Diagramm, in welchem abgetragene Schichtdicken von N- und P-dotiertem Silicium bei einer festgelegten Ätzdauer und einer festgelegten Stromdichte über der Bestrahlungsstärke aufgetragen sind und,

Fig. 4A in schematischer Querschnittsdarstellung einen zu ätzenden Körper und ein auf dem Körper aufgebrachtes System von Leiterzügen und Verbindungen gemäß einer weiteren Ausführungsform der Erfindung, die dazu dient, den Körper an mehreren Stellen gleichzeitig zu ätzen,

Fig. 4B im Querschnitt den in der Fig. 4A gezeigten Körper nach Abschluß des Ätzens gemäß dem erfindungsgemäßen Verfahren unter Anwendung des in der Fig. 4A gezeigten Systems von Leiterzügen und Verbindungen,

Fig. 4C im Querschnitt den in der Fig. 4A gezeigten Körper nach Abschluß des Ätzens gemäß dem erfindungsgemäßen Verfahren unter Anwendung des in der Fig. 4A gezeigten Systems von Leiterzügen und Verbindungen, wobei während des Ätzens an den Leiterzügen bzw. Verbindungen die Potentiale alternierend vertauscht werden,

Fig. 5 in Aufsicht ein System von Leiterzügen und Verbindungen auf einem Halbleiterplättchen, mit dem Zweck, das Halbleiterplättchen an sehr vielen Stellen gleichzeitig selektiv ätzen zu können,

Fig. 6A einen Querschnitt durch ein verschiedene dotierte Schichten aufweisendes Halbleiterplättchen, welches gemäß dem erfindungsgemäßen Verfahren geätzt worden ist,

Fig. 6B denselben Querschnitt wie in der Fig. 6A, nachdem an dem Halbleiterplättchen einige weitere Verfahrensschritte durchgeführt worden sind, bei denen ein Inverter mit Feldeffekttransistoren und den notwendigen Leiterzügen erzeugt worden ist, und

Fig. 6C das Ersatzschaltbild des in der Fig. 6B gezeigten Inverters.

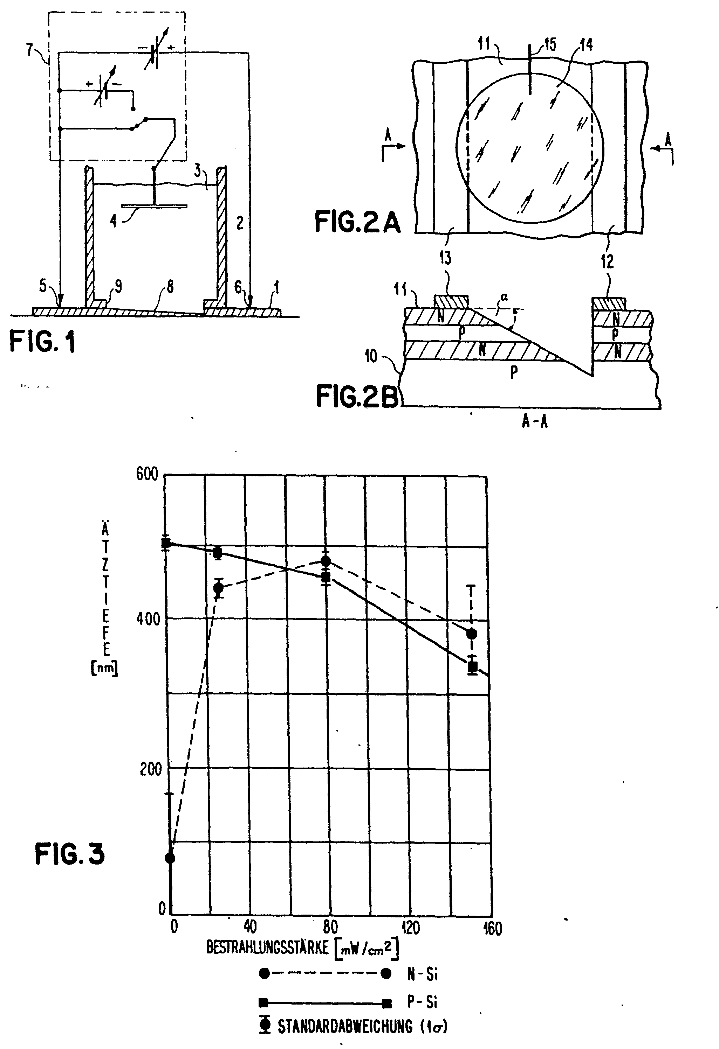

Die in der Fig. 1 gezeigte Anordnung bzw. Vorrichtung dient zum selektiven Ätzen der Oberfläche eines Körpers 1. In der folgenden Beschreibung besteht der zu ätzende Körper immer aus einem Silicium- bzw. Halbleiterplättchen. Zu der Vorrichtung gehört ein zur Aufnahme des Elektrolyten 3 bestimmter Behälter 2, welcher aus einem Material besteht, welches von dem Elektrolyten nicht angegriffen wird. Ein geeignetes Material, welches gegenüber sehr vielen Elektrolyten, beispielsweise auch gegenüber der zum Ätzen von Silicium benutzten Flußsäure, ätzbeständig ist, ist Teflon. Der Behälter 2 hat im Boden eine Öffnung 9, welche mit dem zu ätzenden Siliciumplättchen 1 verschlossen wird. Die Dichtung zwischen dem Behälter 2 und dem Siliciumplättchen 1 wird mittels eines nicht gezeigten Rings aus Viton (WZ), einem linearen Copolymer aus Vinylidenfluorid und Hexafluorpropylen gewährleistet. In den Elektrolyten taucht eine Kathode 4 ein, welche aus einem leitfähigen Material besteht, welches vom Elektrolyten nicht angegriffen wird. Ein Material, welches in den meisten Fällen dieser Anforderung gerecht wird, ist Platin. Die Kathode muß nicht in irgendeiner besonderen Weise geformt sein. Beispielsweise kann die Kathode aus einem dünnen Draht bestehen. Die Kathode ist mit einer Stromquelle 7 verbunden, mit der auch das Siliciumplättchen 1 über die Verbindungen 5 und 6 leitend verbunden ist. In der Fig. 1 ist die Stromversorgung in einem Betriebszustand gezeigt, in dem das Kathodenpotential und das an der Verbindung 5 liegende Potential dasselbe Niveau haben. Die Stromversorgung 7 kann aber auch, indem der Schalter (s. Fig. 1) in der Stromversorgung umgelegt wird, betrieben werden, daß die an der Kathode 4 und an den Verbindungen 5 und 6 liegenden Potentiale voneinander verschieden sind. In jedem Fall muß sichergestellt sein, daß an der Verbindung 6 das positivste Potential liegt. Die üblicherweise rechteckige Fläche 8 auf dem Siliciumplättchen 1, welche geätzt wird, ist begrenzt entweder durch den Viton-Ring oder durch eine die nicht zu ätzenden Bereiche abdeckende Maskierung aus einem vorzugsweise isolierenden und gegenüber dem Elektrolyten resistenten Material oder — und das ist der üblichste Fall — auf zwei einander gegenüberliegenden Seiten durch sehr gut leitende und mit dem Siliciumplättchen 1 leitend verbundene Bereiche, an denen über Leitungen zu den Verbindungen 5 und 6 je eines der Anodenpotentiale liegt, und welche auch maskierend wirken, und im übrigen durch Bereiche aus dem vorzugsweise isolierenden, ätzresistenten Maskenmaterial. Die sehr gut leitenden Bereiche und die sehr gut leitenden Leitungen zwischen diesen Bereichen und den Stellen, an denen die Verbindungen 5 und 6 mit dem Halbleiterplättchen verbunden sind, wurden bevorzugt hergestellt, indem ganzflächig ein ätzresistentes Metall, z. B. Gold, auf das Siliciumplättchen aufgedampft wird und anschließend mittels eines sehr unkritischen photolithographischen Verfahrens die Bereiche und die Leitungen erzeugt werden.

Unterscheiden sich die an der Kathode 4 und den Punkten 5 und 6 liegenden Potentiale, so erfolgt beim Ätzen auf der gesamten, dem Elektrolyt ausgesetzten Fläche eine Abtragung, wobei an der an dem positiveren Potential liegenden Seite der zu ätzenden Fläche die Abtragung am stärksten und dort, wo das andere Potential anliegt am geringsten ist. Da zwischen den angelegten Potentialen innerhalb der zu ätzenden Fläche 8 ein Spannungsabfall stattfindet, nimmt die Abtragungsgeschwindigkeit zwischen der Stelle mit der geringsten und der Stelle mit der stärksten Abtragungsgeschwindigkeit linear zu. Das Ergebnis der Ätzung ist deshalb eine bezüglich der ursprünglichen Siliciumoberfläche linear abfallende Fläche.

Liegen das Kathodenpotential und eines der an dem Siliciumplättchen liegenden Potentiale auf dem gleichen Niveau, so sind die Verhältnisse nur insofern anders, daß dort, wo das Potential der Kathode an der zu ätzenden Fläche anliegt, nicht einmal eine geringe, sondern überhaupt keine Abtragung stattfindet. Auch hier erhält man also eine bezüglich der ursprünglichen Siliciumoberfläche linear abfallende Fläche, wobei keine Stufe zwischen der ursprünglichen Siliciumoberfläche und der linear abfallenden Fläche vorhanden ist, wie es der Fall ist, wenn die drei Potentiale unterschiedlich sind. Liegen das Kathodenpotential und eines der am Siliciumplättchen liegenden Potentiale auf demselben Niveau, so ist der Neigungswinkel der linear abfallenden Fläche allein durch die Menge des abgetragenen Materials bestimmt.

Beim Ätzen von Silicium wird als Elektrolyt Flußsäure verwendet, wobei mit einer ungefähr 5gew.%igen Flußsäure besonders gute Ergebnisse erzielt werden. Es wird bei Zimmertemperatur geätzt. Bei Silicium wurden mit durchschnittlichen Stromdichten von $\leq 200$ mA/cm$^2$ gute Ergebnisse, d. h., Flächen mit einem einheitlichen Neigungswinkel und guter Oberflächenqualität erhalten. Bei einer Stromdichte oberhalb 200 mA/cm$^2$ war die Ätzung nicht mehr gut kontrollierbar. Bei einer Stromdichte von 200 mA/cm$^2$ und unter Bestrahlung mit einer Stärke, die im optimalen Bereich liegt, beträgt die Ätzgeschwindigkeit von Silicium in die Tiefe 0,064 $\mu$m pro sec. Da die zu ätzenden Vertiefungen oft Tiefen in der Größenordnung von 1 $\mu$m haben, d. h., die Ätzdauern in der Größenordnung von 15 Sekunden liegen, leuchtet es ein, daß wegen der Abhängigkeit der Ätztiefe von der Ätzdauer es schwierig ist, Vertiefungen mit festgelegter Tiefe reproduzierbar zu erzeugen, wenn so vorgegangen wird, daß der Strom einmal ein und nach 15 bis 20 Sekunden wieder abgeschaltet wird. Aus diesem Grund wird gepulst geätzt. Die Pulsdauern können bei der verwendeten Stromversorgung zwischen 0,1 und 1,5 Sekunden liegen. Durch das gepulste Ätzen wird auch ein übermäßiges Erwärmen des Elektrolyten während des Ätzens vermieden.

Beim Ätzen von schwach N-dotiertem Silicium ist es erforderlich, die zu ätzende Fläche mit einer Lampe mit einem großen Lichtanteil im nahen Infrarot zu bestrahlen. Diese Bestrahlung ist notwendig, da im N-dotierten Silicium — anders als im P-dotierten — zu wenig Löcher vorhanden sind, um bei einer festgelegten Stromdichte einen homogenen Abtrag sicherzustellen. Dieser Mangel wird durch die Bestrahlung behoben. Damit die Lampe die gewünschte Wirkung hat, muß in ihrem Licht, dessen Wellenlänge einer Energie entspricht, welche etwas geringer als die Bandlücke ist, hoch sein. Die Bandlücke des Siliciums liegt bei ungefähr 1,1 eV, was einer Wellenlänge von ungefähr 1,3 $\mu$m entspricht.

Die in der Fig. 1 gezeigte Vorrichtung läßt sich zum Herstellen von »Schrägschliffen« an Testplättchen, d. h., an Siliciumplättchen, welche für Charakterisierungszwecke mit den integrierte Schaltungen tragenden Produktplättchen bei Dotierungsoperationen mitprozessiert werden, und welche dabei ganzflächig beispielsweise einer Diffusionsbehandlung unterworfen werden, verwenden. Die mittels der erfindungsgemäßen Vorrichtung und des erfindungsgemäßen Verfahrens hergestellte, geneigte Fläche, welche im Querschnitt in der Fig. 1 gezeigt und mit der Nummer 8 bezeichnet ist, kann, wenn es sich bei dem in der Fig. 1 gezeigten Siliciumplättchen 1 um ein solches Testplättchen, welches eine Diffusionsbehandlung durchgemacht hat, handelt, dazu benutzt werden, um gemäß der bekannten Anfärbemethode zur Messung der Eindringtiefe und mittels der punktweisen Messung des Ausbreitungswiderstandes entlang der Fallinie der geneigten Fläche zur Messung des Dotierungsprofils benutzt werden.

Mit der in der Fig. 2A gezeigten Vorrichtung bzw. Anordnung ist es möglich, eine Ätzung innerhalb eines sehr kleinen Bereichs, beispielsweise in dem Gebiet eines Halbleiterplättchens, welches sich zwischen den Chips befindet und welches beim Zerschneiden des Halbleiterplättchens in Chips wegfällt, vorzunehmen. Die Fig. 2A zeigt in Aufsicht Ausschnitte aus zwei Leiterzügen 12 und 13 auf der Oberfläche 11 eines Siliciumplättchens. In dem Raum zwischen den beiden Leiterzügen 12 und 13 ist ein Tropfen 14 wäßriger Flußsäure so aufgebracht, daß er auch die beiden Leiterzüge 12 und 13 kontaktiert. In den Elektrolyttropfen taucht von oben ein Platindraht 15 ein. Werden nun die Leiterzüge 12 und 13 und der Platindraht 15 an ein Stromversorgungsgerät so angeschlossen, daß der Platindraht 15 zur Kathode wird, der Leiterzug 13 auf demselben Potential wie die Kathode und der Leiterzug 12 auf einem positiveren Potential als die Kathode liegt, so wird das Silicium zwischen den Leiterzügen 12 und 13 derart geätzt, daß die Ätzgeschwindigkeit senkrecht zu den Leiterzügen 12 und 13 linear zunimmt, wobei in unmittelbarer Nähe des Leiterzugs 13 die Ätzgeschwindigkeit Null ist. Dieses Ergebnis gibt die Fig. 2B wieder, welche einen Schnitt durch die in der Fig. 2A gezeigte Anordnung entlang der Linie A-A zeigt. Fig. 2B zeigt, daß man auch dann ein linear geneigtes Schnittprofil erhält, wenn das Siliciumplättchen aus einem P-dotiertem Substrat 10 besteht, auf welchem, beispielsweise mittels des bekannten Epitaxieverfahrens der Reihe nach eine N-, eine P- und schließlich noch einmal eine N-dotierte Siliciumschicht aufgebracht worden ist. Voraussetzung dafür ist, daß die zu ätzende Probe während des Ätzens mit einer festgelegten Bestrahlungsstärke bestrahlt wird.

Der Einfluß der Bestrahlung auf das Ätzen soll anhand der Fig. 3 erläutert werden. Die Fig. 3 zeigt ein Diagramm, in der durch elektrochemisches Ätzen abgetragene Schichtdicken von P- und N-dotiertem Material über den Bestrahlungsstärken, denen das P- und N-dotiertes Silicium während des Ätzens ausgesetzt waren, aufgetragen sind. Beim Ätzen wurde so vorgegangen, daß an dem zu ätzenden Material jeweils nur ein Potential anlag, so daß das Material gleichmäßig abgetragen wurde, d. h., daß beim Ätzen Vertiefungen mit zur Oberfläche, von der ausgegangen wurde, parallelen Böden entstanden. Zum Bestrahlen der zu ätzenden Proben wurde eine Halogenlampe mit Goldreflektor, welche von der Firma Osram unter der Typennummer 64635 vertrieben wird, verwendet. Die Lampe ist vorteilhaft, da in ihrem Licht der Anteil, dessen Wellenlänge einer Energie entspricht, welche etwas geringer als die Bandlücke ist, hoch ist. Die Bandlücke des Siliciums liegt bei ungefähr 1,1 eV, was einer Wellenlänge von ungefähr 1,3 μm entspricht. Die Lampe hatte von der zu ätzenden Probe ein Abstand von 5,0 cm und die Schichtdicke des aus 5gewichtsprozentiger Flußsäure bestehenden Elektrolyten über der zu ätzenden Probe betrug 2,5 cm. In dem Elektrolyten wird längerwelliges Infrarotlicht stark absorbiert. Geätzt wurden jeweils 0,5 mm$^2$ große Flächen, indem sie bei einer Stromdichte von 100 mA/cm$^2$ 15 Sekunden lang mit dem Elektrolyten behandelt wurden. Die Lampenleistung wurde im Bereich zwischen 0 und 150 Watt (entsprechend einer Bestrahlungsstärke von 0 bis etwa 150 mW/cm$^2$) variiert.

Aus dem Diagramm ersieht man in erster Linie, daß — wie schon gesagt — die Geschwindigkeit, mit der sowohl N-dotiertes Silicium als auch P-dotiertes Silicium abgetragen wird, von der Bestrahlungsstärke abhängen, daß es eine Bestrahlungsstärke gibt, bei der N- und P-dotiertes Silicium etwa mit derselben Geschwindigkeit geätzt werden und die etwa die obere Grenze eines größeren Bestrahlungsstärkenbereiches bildet, in welchem die Ätzgeschwindigkeiten beim Abtragen von P- und N-dotiertem Material nicht sehr voneinander verschieden sind und außerdem relativ wenig von der Bestrahlungsstärke abhängig sind. Die genannte Bestrahlungsstärke liegt bei 70 mW/cm$^2$ (entsprechend einer Lampenleistung von 80 Watt). Außerdem ist der Fig. 3 zu entnehmen, daß bei Bestrahlungsstärken ≥ 150 mW/cm$^2$ (entsprechend einer Lampenleistung von ≥ 150 Watt), die Geschwindigkeit, mit welcher N-dotiertes Silicium geätzt wird, schlecht reproduzierbar ist, und daß bei Bestrahlungsstärken < 25 mW/cn$^2$ (entsprechend einer Lampenleistung von ungefähr < 50 Watt) die Geschwindigkeit, mit welcher N-dotiertes Silicium abgetragen wird, sehr stark von der Bestrahlungsstärke abhängt. Wie festgestellt wurde, ist die schlechte Reproduzierbarkeit des Ätzens bei kleinen Bestrahlungsstärken darauf zurückzuführen, daß dabei kein paralleler Schichtabtrag erfolgt, sondern eine Oberfläche erhalten wird, die neben Bereichen, welche kaum angegriffen sind, sehr tiefe Gräben aufweist.

Die der Fig. 3 zugrundeliegenden Messungen wurden an Proben aus P- und N-dotiertem Silicium, welche jeweils ungefähr 7 × 10$^{15}$ Dotierungsatome/cm$^3$ enthielten, durchgeführt. Die in der Fig. 3 aufgezeigten Ergebnisse sind jedoch repräsentativ für einen großen Bereich sowohl der N- als auch der P-Dotierungskonzentration.

Dies wurde anhand von Versuchen festgestellt, bei welchen 3 Proben aus P-dotiertem Silicium, deren Dotierungskonzentrationen zwischen 1 × 10$^{15}$ und 1 × 10$^{19}$ Dotierungsatomen/cm$^3$ lagen und 7 Proben N-dotiertem Silicium, deren Dotierungskonzentration zwischen 1 × 10$^{15}$ und 5 × 10$^{19}$ Dotierungsatomen/cm$^3$ lagen, geätzt wurden. Bei allen Versuchen wurde mit derselben Bestrahlungsstärke und auch sonst bei gleichen Bedingungen geätzt. Es wurde gefunden, daß bei den Proben vom gleichen Leitfähigkeitstyp innerhalb der Meßgenauigkeit die Abtragungsgeschwindigkeit konstant, d. h. unabhängig von der Dotierungskonzentration war.

Mit dem erfindungsgemäßen Verfahren, ist es, wie die eben besprochenen Messungen zeigen, möglich, P- und N-dotiertes Silicium elektrochemisch mit genau definierter Abtragungsgeschwindigkeit zu ätzen. Insbesondere ist es möglich, durch eine entsprechende Einstellung der Bestrahlungsstärke P- und N-dotiertes Material mit derselben Geschwindigkeit abzutragen. Dadurch werden viele Anwendungen, bei denen P- und N-dotierte Siliciumbereiche entweder gleichzeitig oder nacheinander geätzt werden, wesentlich vereinfacht oder sogar erst ermöglicht. Beispielsweise läßt sich so auch das in der Fig. 2B gezeigte Ätzprofil erzeugen.

Auch dann, wenn das Siliciumplättchen, dessen Ätzung anhand der Fig. 2A und 2B weiter oben besprochen wurde, so selektiv geätzt werden soll, daß eine gleichmäßige Abtragung, d. h. eine Abtragung parallel zur Oberfläche 11, erfolgen soll (dies wird erreicht, indem beim Ätzen an den Leiterzügen 12 und 13 dasselbe Potential liegt), ist es vorteilhaft, wenn die N- und P-dotierten Schichten einerseits mit definierter und andererseits mit derselben Geschwindigkeit abgetragen werden. Nur dann nämlich, wenn die Abtragungsgeschwindigkeit bekannt ist und für P- und N-dotiertes Silicium gleich ist, läßt sich durch einfache Versuche beispielsweise an einheitlich dotierten Testplättchen die Zeitdauer ermitteln, welche erforderlich ist, um die Epitaxieschicht bis zum P-dotierten Substrat selektiv wegzuätzen.

Dieselbe Abtragungsgeschwindigkeit beim Ätzen von P- und N-Silicium oder wenigstens eine Abtragungsgeschwindigkeit, welche für die beiden Materialien eindeutig definiert ist, ist auch notwendig, wenn bei der Messung des vertikalen Dotierungsprofils in einem Halbleitersubstrat, in welchem Bereiche, wie z. B. der Emitter- und ein Teil des Basisbereichs in einem Bipolartransistor, übereinanderliegen, welche sich im Leitfähigkeitstyp unterscheiden, so vorgegangen wird, daß das Halbleitermaterial Schicht um Schicht abgetragen wird und nach jeder Abtragung einer Schicht der Schichtwiderstand ($R_s$) gemessen wird. Wenn dabei nicht genau bekannt ist, wie dick die bei jedem Abtragungsschritt abgetragenen Schichten sind, so ist die Ermittlung des Diffusionsprofils, d. h. die Kurve welche erhalten wird, wenn die Dotierungskonzentration über den zugehörigen Abstand zur Substratoberfläche aufgetragen wird, nicht möglich.

Daß die Abtragung von Silicium beim elektrochemischen Ätzen in wäßriger Flußsäure, abgesehen von der Bestrahlung, nur von der überführten Ladung, aber nicht vom Leitungstyp und von der Dotierungskonzentration abhängt, wurde durch Versuche bestätigt. In der folgenden Tabelle sind von 9 Proben der Leitungstyp, die Dotierungskonzentration, die Bedingungen unter denen sie geätzt wurden und die dabei erzielten Ergebnisse aufgelistet. Die Abtragung erfolgte bei allen Proben parallel zur ursprünglichen Halbleiteroberfläche.

# 0 018 556

Tabelle

| Versuchs-nummer | Leitungs-typ | Dotierungs-stoff konz. Atom/cm$^3$ | Überführte Ladung in A sec | dabei erreichte Ätztiefe in $\mu$m | Abgetragenes Volumen/A sec (mm$^3$/A sec) | Bedingungen | Bemerkungen |
|---|---|---|---|---|---|---|---|
| 1 | N | $10^{17}$ | $6{,}51 \cdot 10^{-3}$ | 0,36 | $2{,}82 \cdot 10^{-2}$ | mit Beleuchtung, gepulste Ätzung | Abtrag homogen |
| 2 | N | $2 \cdot 10^{17}$ | $7{,}8 \cdot 10^{-3}$ | 0,48 | $3{,}14 \cdot 10^{-2}$ | desgl. | desgl. |
| 3 | N | $10^{18}$ | $2{,}86 \cdot 10^{-3}$ | 0,19 | $3{,}38 \cdot 10^{-2}$ | desgl. | desgl. |
| 4 | N | $10^{18}$ | $4{,}03 \cdot 10^{-3}$ | 0,23 | $2{,}91 \cdot 10^{-2}$ | desgl. | desgl. |
| 5 | N | $10^{20}$ | $8{,}24 \cdot 10^{-3}$ | 0,54 | $3{,}34 \cdot 10^{-2}$ | desgl. | desgl. |
| 6 | P | $10^{17}$ | $6{,}08 \cdot 10^{-3}$ | 0,39 | $3{,}27 \cdot 10^{-2}$ | desgl. | desgl. |
| 7 | P | $10^{18}$ | $10{,}85 \cdot 10^{-3}$ | 0,70 | $3{,}29 \cdot 10^{-2}$ | desgl. | desgl. |
| 8 | P | $10^{20}$ | $1{,}97 \cdot 10^{-3}$ | 0,12 | $3{,}10 \cdot 10^{-2}$ | Ohne Beleuchtung | desgl. |
| 9 | N | $10^{18}$ | — | — | — | Ohne Beleuchtung | zernarbte Oberfläche, keine definierte Messung mögl. |

Geätzt wurde jeweils eine 0,5 mm$^2$ große Fläche. Bei allen Versuchen lagen die Stromdichten zwischen 50 und 150 mA/cm$^2$. Zur Beleuchtung wurde der Halogen-Infrarot-Reflektorstrahler Nr. 64635 von der Firma Osram verwendet. Die Bestrahlungsstärke wurde bei den Versuchen 1—7 so eingestellt, daß P- und N-Silicium bei sonst gleichen Bedingungen etwa mit derselben Geschwindigkeit geätzt wurden. Die sich aus der Tabelle ergebenden Schwankungen der Ätgeschwindigkeit liegen innerhalb der ±0,03 $\mu$m liegenden Meßungenauigkeit des verwendeten Dicken-Meßgeräts.

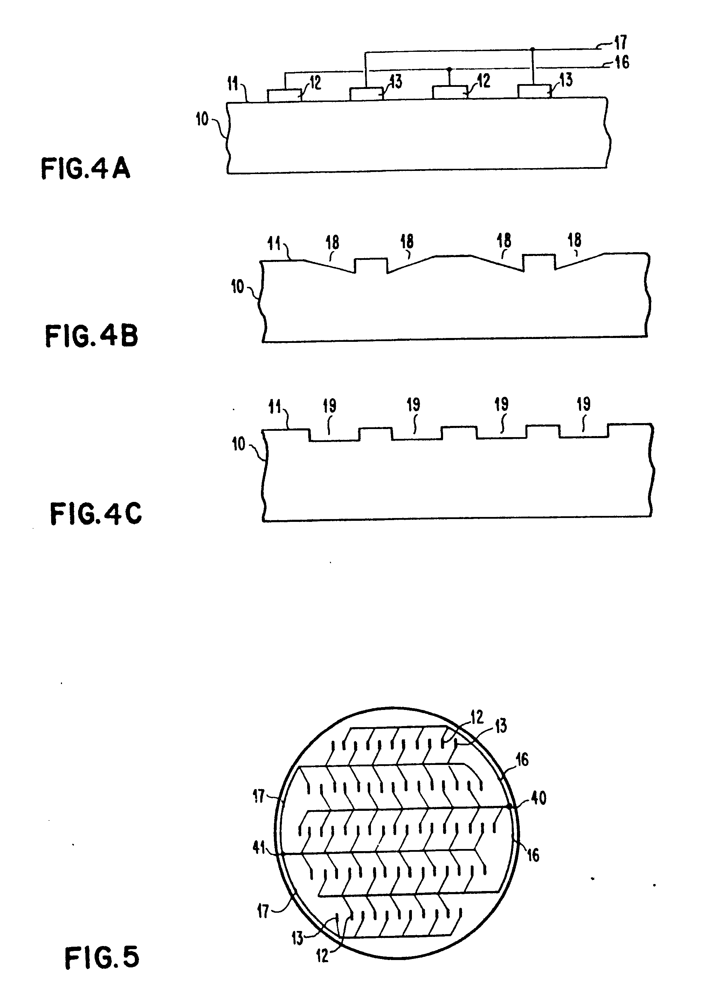

Anhand der Fig. 4A bis 4C soll nun erläutert werden, wie mittels der Fig. 4A gezeigten Anordnung, welche im Prinzip der in der Fig. 2A gezeigten Anordnung ähnlich ist, eine Vielzahl von Vertiefungen, welche entweder einen gegenüber der Oberfläche geneigten (Fig. 4B) oder einen zur Oberfläche parallelen Boden (Fig. 4C) aufweisen. Auf der Oberfläche 11 des Halbleiterplättchens 10, welches in der Fig. 4A im Querschnitt gezeigt ist, sind Leiterzüge 12 und 13 aufgebracht, welche mindestens an den Stellen, an welchen später geätzt werden soll, parallel zueinander verlaufen. In der Fig. 4A sind auch schematische Verbindungen 16 und 17 gezeigt, welche die Leiterzüge 12 bzw. 13 untereinander und mit dem nicht gezeigten Stromversorgungsgerät verbinden. In der Realität können die Verbindungen 16 und 17 in der gleichen Ebene wie die Leiterzüge 12 und 13 oder auch in einer darüber liegenden Ebene liegen, welche von der die Leiterzüge 12 und 13 bildenden Ebene — abgesehen von senkrecht verlaufenden Verbindungsstücken — durch eine isolierende Schicht getrennt ist. Die Leiterzüge bestehen aus einem Material, welches von der Flußsäure höchstens sehr wenig angegriffen wird, beispielsweise aus Gold und/oder sie sind mittels einer passivierenden Schicht, welche aus einem Oxid, Siliciumnitrid oder Photolack besteht, vor dem Ätzangriff der Flußsäure geschützt. Zum Ätzen wird das Halbleiterplättchen 10 vorzugsweise in der folgenden Weise vorbereitet: Auf dem Halbleiterplättchen werden die Leiterzüge 12 und 13 und die Verbindungen 16 und 17, sofern diese auf derselben Ebene wie die Leiterzüge liegen sollen, mittels irgendwelcher bekannter Verfahren, beispielsweise mittels ganzflächigen Aufdampfens des Leiterzugmaterials und anschließenden subtraktiven Ätzens oder mittels des Abhebeverfahrens (lift-off) erzeugt. Anschließend wird ganzflächig eine Schicht aus einem gegenüber Flußsäure resistenten, isolierenden Material aufgebracht. Nun wird auf photolithographischem Weg, dort wo das Halbleitermaterial geätzt werden soll, das resistente Material entfernt und in dieses Material entweder je ein Kontaktloch zu den Verbindungen 16 und 17 oder, sofern diese Verbindungen noch nicht erzeugt worden sind, zu jedem Leiterzug 12 und 13 je ein Durchführungsloch geätzt. Müssen die Verbindungen 16 und 17 noch erzeugt werden, so werden diese mittels des

8

Abhebeverfahrens auf der Schicht aus dem resistenten Material unter Berücksichtigung der Durchführungslöcher und der freiliegenden Halbleiterflächen aus einem gegen Flußsäure resistenten leitfähigen Material hergestellt. Als resistentes isolierendes Material kommen die zum Abdecken der Leiterzüge genannten Materialien in Frage.

Auf das so präparierte Halbleiterplättchen wird nun ein Gefäß gestülpt, wie es anhand der Fig. 1 besprochen worden ist. Das Gefäß hat in diesem Fall eine Öffnung am Boden, welche so groß ist, daß der Teil des Halbleiterplättchens 10, in welchem die zu ätzenden Bereiche liegen, in der Gefäßöffnung freiliegt. Die Dichtung zwischen dem Gefäß und dem Halbleiterplättchen 10 erfolgt wie oben angegeben mittels eines Vitonrings. Die Verbindungen 16 und 17 sind unter dem Vitonring hindurch nach außen geführt. Wird nun ungefähr 5gewichtsprozentige Flußsäure in das Gefäß eingefüllt, ein Platindraht als Kathode in die Flußsäure eingetaucht und der Platindraht und die Verbindung 16 und damit auch die Leiterzüge 12 auf dasselbe und die Verbindung 17 und damit auch die Leiterzüge 13 auf ein gegenüber dem Kathodenpotential positiveres Potential gelegt, so erhält man nach einer festgelegten Anzahl von Ätzimpulsen eine Struktur, welche die Fig. 4B im Querschnitt nach der Entfernung der Leiterzüge 12 und 13 und der Verbindungen 16 und 17 zeigt. Man erkennt die Vertiefungen 18 mit geneigtem Boden. Zur Herstellung der in der Fig. 4C im Querschnitt gezeigten Struktur mit einem waagrechten Boden aufweisenden Vertiefungen 19 muß die Stromversorgung anders erfolgen als bei der Herstellung der in Fig. 4B gezeigten Struktur: Entweder liegen die Verbindungen 16 und 17 auf demselben, gegenüber der Kathode positiveren Potential oder liegt zwar die eine der Verbindungen 16 bzw. 17 auf dem Kathodenpotential und die andere auf einem demgegenüber positiveren Potential, jedoch wechselt die auf dem Kathodenpotential liegende und entsprechend die auf dem positiveren Potential liegende Verbindung bei jedem Ätzpuls.

Eine Möglichkeit der Bedeckung eines Halbleiterplättchens mit Leiterzügen 12 und 13 und mit Verbindungen 16 und 17, welche alle in einer Ebene liegen, zeigt die Fig. 5. Das Halbleiterplättchen ist dabei so maskiert, daß nur Bereiche zwischen jeweils benachbarten Leiterzügen 12 und 13 dem Ätzangriff ausgesetzt sind. Das Halbleiterplättchen ist über die Anschlüsse 40 und 41 mit der (nicht gezeigten) Stromversorgung verbunden.

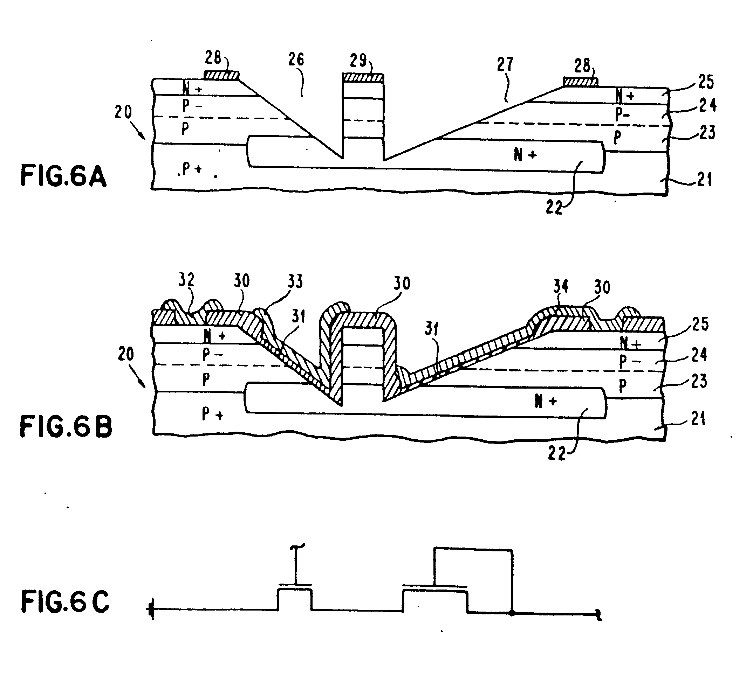

Im folgenden wird anhand der Fig. 6A bis 6C eine beispielhafte Anwendung des erfindungsgemäßen Verfahrens bei der Herstellung dicht gepackter integrierter Schaltungsbausteine beschrieben. In der Fig. 6A ist ein Ausschnitt aus einem Siliciumplättchen 20 im Querschnitt gezeigt, welches ein P+-dotiertes Substrat 21 aufweist, in welchem ein N+-dotierter Bereich 22 beispielsweise mittels einer Diffusion erzeugt worden ist und auf welches eine P-dotierte Epitaxieschicht 23 und auf dieser eine P−-dotierte Epitaxieschichicht 24 aufgewachsen worden ist, wobei ein Teil des Dotierungsstoffs im Bereich 22 in die aufwachsende Epitaxieschicht 23 eingebaut worden ist. Die Epitaxieschicht 24 wurde mittels eines bekannten Dotierungsverfahrens, beispielsweise mittels Diffusion oder Ionenimplantation oberflächlich in eine N+-dotierte Schicht 25 umgewandelt. Auf die Halbleiteroberfläche sind mittels bekannter Verfahren die Leiterzüge 28 und 29 aufgebracht worden. In diese Struktur wurden mittels des erfindungsgemäßen Verfahrens die Vertiefungen 26 und 27 geätzt, indem — wie oben beschrieben — die Siliciumoberfläche einer ungefähr 5gewichtsprozentigen Flußsäurelösung ausgesetzt wurde und an die Leiterzüge 28 dieselbe Spannung wie an die Kathode gelegt wurde und durch eine entsprechende Stromführung und Einstellung der Stromdichte erreicht wurde, daß an den Leiterzug 29 ein um etwa 30 V positiveres Potential als an der Kathode lag. Da durch eine P- und N-dotierte Schichten aufweisende Struktur hindurch geätzt werden sollte und dabei ebene, geneigte Flächen entstehen sollten, wurde außerdem bestrahlt, wobei — wie oben angegeben — die Bestrahlungsstärke so eingestellt wurde, daß P- und N-dotierte Schichten gleich schnell geätzt wurden. Man sieht, daß in der Vertiefung 27 die geneigte Fläche in der Fallinie länger und eine geringere Neigung gegenüber der Halbleiteroberfläche aufweist als die geneigte Fläche in der Vertiefung 26. Dies wird einfach dadurch erreicht, daß die Leiterzüge 28 und 29 so aufgebracht werden, daß die die Vertiefung 27 begrenzenden Leiterzüge einen größeren Abstand voneinander haben als die die Vertiefung 26 begrenzenden Leiterzüge. Dadurch daß der Leiterzug 29 sowohl die Vertiefung 27 als auch die Vertiefung 26 begrenzt, ist sichergestellt, daß an beide zu ätzenden Flächen dasselbe positive Potential anliegt und deshalb beide Vertiefungen bis in dieselbe Tiefe reichen. Wie man sieht reicht die geneigte Fläche in den Vertiefungen 26 und 27 von der N+-dotierten Schicht 25 bis in den N+-dotierten Bereich 22 hinein. Nach dem Entfernen der Leiterzüge 28 und 29 wurde thermisch oxidiert, wobei die dicke Oxidschicht 30 entstand. Anschließend wurden in die Oxidschicht 30 Fenster zu der N+-dotierten Schicht 25 und außerdem in den Vertiefungen je eine Öffnung derart geätzt, daß die geneigten Flächen im P-dotierten Bereich freigelegt wurden. Anschließend wurde in den Öffnungen in den Vertiefungen 26 und 27 dünne Oxidschichten 31 aufgewachsen und schließlich wurden die Kontakte bzw. Leitungen 32, 33 und 34 mittels bekannter Verfahren hergestellt. Die dann vorliegende Struktur zeigt die Fig. 6B im Querschnitt. Das Ersatzschaltbild der erzeugten Schaltung ist in der Fig. 6C abgebildet. Es handelt sich dabei um einen Inverter. Für ein Inverter ist wesentlich, daß der eine Feldeffekttransistor einen größeren Kanalwiderstand als der andere hat. Mit dem erfindungsgemäßen Verfahren ist es ohne weiteres möglich dieser Forderung auch dann zu genügen, wenn die Kanäle entlang geneigter Flächen verlaufen, indem einfach geneigte Flächen mit unterschiedliche Neigungswinkel und dadurch unterschiedliche Kanallängen erzeugt werden. Mittels der bekannten V-Kerben-technik, auf welche in der Einleitung eingegangen worden ist, ist es nicht so leicht möglich in den Kerben erzeugte Feldeffekttransistoren mit unterschiedlichen Kanalwiderständen zu erzeugen.

Andere Anwendungsmöglichkeiten der Erfindung insbesondere bei der Herstellung von miniaturisierten Bauteilen sind beispielsweise das Ätzen von Tintenstrahldrucker-Düsen und die Erzeugung von Isolationswannen zur Isolation von Halbleiterbauteilen voneinander, wobei das »Vogelschnabel«-Problem, welches beim Füllen der Wanne mit $SiO_2$ mittels thermischer Oxidation auftritt, verkleinert wird.

Abschließend ein Ausführungsbeispiel:

Unter Verwendung einer Anordnung, wie sie in der Fig. 1 dargestellt ist, wurde eine 0,5 $cm^2$ große Fläche eines Siliciumplättchens mittels des erfindungsgemäßen Verfahrens geätzt. Das Siliciumplättchen war homogen dotiert, hatte P-Leitfähigkeit und die Konzentration des Dotierungsstoffs lag bei $7 \cdot 10^{14}$ Atomen/$cm^3$. Auf das runde Siliciumplättchen war in Form zweier Segmente eine dünne Goldschicht aufgebracht worden. Die beiden Goldsegmente hatten zwei zueinander parallele Sekanten, deren Abstand voneinander gleich der Länge der zu ätzenden Fläche war. Als Elektrolyt wurde 5gewichtsprozentige Flußsäure verwendet. An die Goldsegmente wurden unterschiedliche Spannungen gelegt, von denen die eine gleich dem Kathodenpotential und die andere positiver als das Kathodenpotential war. Es wurde gepulst, geätzt. Während der Ätzpulse wurde eine durchschnittliche (über die zu ätzende Fläche) Stromdichte von 200 mA/$cm^2$ konstant aufrechterhalten, wobei eine Stromversorgung verwendet wurde, welche eine Spannung von bis zu 100 V zwischen Kathode und Anode aufrechtzuerhalten erlaubt. Die Ätzpulse hatten eine Dauer von 1 sec. Nach ungefähr 3300 Ätzpulsen wurde eine senkrecht zu den Sekanten der Goldsegmente linear geneigte Fläche mit einem Neigungswinkel gegenüber der ursprünglichen Oberfläche von 6° erhalten. Die geneigte Fläche hatte eine sehr gute Oberflächenqualität.

## Patentansprüche

1. Verfahren zum selektiven, elektrochemischen Ätzen von Werkstückoberflächen aus Halbleitermaterial, bei dem an dem Werkstück (1, 10, 20) zwei Potentiale liegen, von denen das eine mindestens so positiv wie das Kathodenpotential und das andere positiver als das Kathodenpotential ist, und bei dem eine festgelegte Stromdichte zwischen Werkstück und Kathode eingestellt wird, während sich die Potentiale aufgrund des Stroms und der zu überwindenden Widerstände einstellen, dadurch gekennzeichnet, daß die dem Ätzmedium ausgesetzte Fläche während des Ätzens zur Beeinflussung der Ätzung mit nahem Infrarotlicht bestrahlt wird.

2. Verfahren nach Anspruch 1, dadurch gekennzeichnet, daß eine durchschnittliche (über die zu ätzende Fläche) Stromdichte von <200 mA/$cm^2$ eingestellt wird.

3. Verfahren nach einem oder mehreren der Ansprüche 1 oder 2, dadurch gekennzeichnet, daß gepulst geätzt wird.

4. Verfahren nach einem oder mehreren der Ansprüche 1 bis 3, dadurch gekennzeichnet, daß an einander gegenüberliegenden Seiten des zu ätzenden Bereichs bzw. der zu ätzenden Bereiche der Werkstückoberfläche (11) je ein Potential gelegt wird und die nicht zu ätzenden Bereiche maskiert werden.

5. Verfahren nach einem oder mehreren der Ansprüche 1 bis 4, dadurch gekennzeichnet, daß zur Herstellung von Vertiefungen (19) mit zur ursprünglichen Oberfläche (11) parallelem Boden jeweils nach festgelegten konstanten Bruchteilen der Ätzzeit die beiden an der Anode liegenden Potentiale vertauscht werden.

6. Verfahren nach einem oder mehreren der Ansprüche 1 bis 4, dadurch gekennzeichnet, daß zur Herstellung von Vertiefungen (19) mit zur ursprünglichen Werkstückoberfläche (11) parallelem Boden an die gesamte zu ätzende Fläche dasselbe Potential gelegt wird.

7. Verfahren nach einem oder mehreren der Ansprüche 1 bis 6, dadurch gekennzeichnet, daß ein Halbleitermaterial aus der Gruppe intrinsisches Silicium, P-dotiertes Silicium, N-dotiertes Silicium, Germanium und Galliumarsenid geätzt wird, wobei zum Ätzen von Silicium 2 bis 10gew.%ige Flußsäure verwendet wird.

8. Verfahren nach einem oder mehreren der Ansprüche 1 bis 7, dadurch gekennzeichnet, daß die Geschwindigkeiten, mit welchen P- und N-dotiertes Silicium geätzt werden, außer über bekannte Parameter, wie die Stromdichte, zusätzlich über die Bestrahlungsstärke, mit welcher die zu ätzende Fläche bestrahlt wird, gesteuert werden.

9. Verfahren nach Anspruch 8, dadurch gekennzeichnet, daß beim Ätzen mit einer mindestens im Wellenlängenbereich von 700 nm bis 1300 nm kontinuierlich emittierenden Lampe mit einer Bestrahlungsstärke bestrahlt wird, welche im Wellenlängenbereich von 720 nm bis 800 nm zwischen etwa 25 mW/$cm^2$ und etwa 150 mW/$cm^2$ liegt, wobei die entsprechenden spektralen Verteilungstemperaturen der Lampe zwischen etwa 2550° K und etwa 3400° K liegen, und die Schichtdicke des Elektrolyten 25 nm beträgt.

10. Anordnung zur Durchführung des Verfahrens nach einem der Ansprüche 1 bis 19, welche eine Stromversorgung, eine Kathode, Mittel, um das Werkstück als Anode zu schalten, und Vorkehrungen, um die zu ätzende Oberfläche mit dem Elektrolyten zu bedecken, aufweist, dadurch gekennzeichnet, daß sie eine Lampe mit einem hohen Lichtanteil im nahen Infrarotbereich zur Bestrahlung der zu ätzenden Fläche aufweist.

11. Anordnung nach Anspruch 10, dadurch gekennzeichnet, daß das Werkstück (20) viele zu ätzende Bereiche, welche je von zwei einander gegenüberliegenden Leiterzügen (12, 13) begrenzt sind und zwei Anschlüsse (40, 41) zum Anlegen der beiden Potentiale aufweist und daß jeder der Leiterzüge (12, 13) über Verbindungen (16, 17) derart mit einem der Anschlüsse (40, 41) verbunden ist, daß benachbarte einander gegenüberliegende Leiterzüge (12, 13) in keinem Fall am gleichen Anschluß (40, 41) liegen.

## Claims

1. Method of selectively electrochemically etching workpiece surfaces of semiconductor material, where two potentials are applied to the workpiece (1, 10, 20) one of which is at least as positive as the cathode potential, and the other more positive than the cathode potential, and where a predetermined current density is set between workpiece and cathode while the potentials are setting on the basis of the current and the resistances to be overcome, characterized in that the surface exposed to the etching medium is irradiated during etching with near infra-red light to influence etching.

2. Method as claimed in claim 1, characterized in that an average (over the surface to be etched) current density of less than 200 mA/cm$^2$ is set.

3. Method as claimed in any one of claims 1 or 2, characterized in that the process is performed with pulsed etching.

4. Method as claimed in one or several of claims 1 to 3, characterized in that on two opposite sides of the area or areas of the workpiece surface (11) to be etched one respective potential is applied, and the areas not to be etched are masked.

5. Method as claimed in one or several of claims 1 to 4, characterized in that for making recesses (19) with a floor that is parallel to the original surface (11) the two potentials at the anode are exchanged after predetermined constant fractions of the etching time.

6. Method as claimed in one or several of claims 1 to 4, characterized in that for making recesses (19) with a floor that is parallel to the original surface (11) the same potential is applied to the entire surface to be etched.

7. Method as claimed in one or several of claims 1 to 6, characterized in that a semiconductor material selected from the group of intrinsic silicon, P-doped silicon, N-doped silicon, germanium and gallium arsenide is etched, 2 to 10 percent by weight hydrofluoric acid being used for etching silicon.

8. Method as claimed in one or several of claims 1 to 7, characterized in that the etching speeds for P- and N-doped silicon are controlled besides via known parameters as current density additionally via the intensity with which the surface to be etched is irradiated.

9. Method as claimed in claim 8, characterized in that during etching there is irradiation with a lamp continuously emitting at least in the wavelength range of 700 nm to 1300 nm, with an irradiation intensity in the wavelength range of 720 nm to 800 nm between approximately 25 mW/cm$^2$ and approximately 150 mW/cm$^2$, the corresponding spectral distribution temperatures of the lamp being between approximately 2550°K and approximately 3400°K, and the layer thickness of the electrolyte being 25 mm.

10. Arrangement for carrying out the method as claimed in any one of claims 1 to 9, comprising a current supply, a cathode, means for making the workpiece into an anode, and means for covering the etching surface with the electrolyte, characterized in that it includes a lamp with a high percentage of light in the near infra-red range for the illumination of the suface to be etched.

11. Arrangement as claimed in claim 10, characterized in that the workpiece (20) shows many areas to be etched, each being limited by two oppositely placed conductive lines (12, 13), as well as two terminals (40, 41) for applying the two potentials, and that each one of the conductive lines (12, 13) is connected via connections (16, 17) to one of the terminals (40, 41) in such a manner that adjacent oppositely placed conductive lines (12, 13) are in no case applied to the same terminal (40, 41).

## Revendications

1. Procédé pour réaliser la gravure électrochimique sélective de surfaces de pièces à traiter constituées en un matériau semiconducteur, selon lequel à la pièce à traiter (1, 10, 20) sont appliqués deux potentiels dont l'un est au moins aussi positif que le potentiel de cathode et dont l'autre est plus positiv que le potentiel de cathode, et selon lequel une densité de courant fixée est réglée entre la pièce à traiter et la cathode, tandis que les potentiels sont réglés en fonction du courant et des resistances à vaincre, caractérisé en ce que la surface soumise à l'action du fluide de gravure est irradiée par une lumière du proche infrarouge pendant la gravure, afin d'influer sur cette dernière.

2. Procédé selon la revendication 1, caractérisé en ce qu'on règle une densité de courant moyenne (sur la surface à graver) inférieure à 200 mA/cm$^2$.

3. Procédé selon une ou plusieurs des revendications 1 ou 2, caractérisé par le fait qu'on effectue une gravure de manière pulsée.

4. Procédé selon une ou plusieurs des revendications 1 à 3, caractérisé en ce qu'on applique un potentiel respectif à des côtés opposés de la région à graver ou des régions à graver de la surface (11) de la pièce à traiter et qu'on masque les zones ne devant pas être gravées.

5. Procédé selon une ou plusieurs des revendications 1 à 4, caracrérisé en ce que pour réaliser des renfoncements (19) comportant un fond parallèle à la surface initiale (11), on permute les deux potentiels appliqués à l'anode, respectivement après des fractions constantes fixées de la durée de gravure.

6. Procédé selon une ou plusieurs des revendications 1 à 4, caractérisé en ce que pour réaliser des renfoncements (19) comportant un fond parallèle à la surface initiale (11) de la pièce à traiter, on applique le même potentiel à l'ensemble de la surface à graver.

7. Procédé selon une ou plusieurs des revendications 1 à 6, caractérisé en ce qu'on effectue la gravure d'un matériau semiconducteur tiré du groupe incluant le silicium intrinsèque, le silicium dopé du type P, le silicium dopé du type N, le germanium et l'arseniure de gallium, en utilisant pour la gravure du silicium de l'acide fluorhydrique à 2 à 10% en poids.

8. Procédé selon une ou plusieurs des revendications 1 à 7, caractérisé en ce qu'on commande les vitesses, avec lesquelles on effectue la gravure du silicium dopé du type P et du silicium dopé du type N, non seulement en fonction de paramètres connus, tels que la densité de courant, mais en outre, en fonction de l'intensité d'irradiation avec laquelle on irradie la surface à graver.

9. Procédé selon la revendication 8, caractérisé en ce que lors de la gravure on effectue une irradiation avec une lampe émettant en continu au moins dans une gamme de longueurs d'onde allant de 700 nm à 1300 nm et possédant une intensité d'irradiation qui se situe dans la gamme des longueurs d'onde allant de 720 nm à 800 nm entre environ 25 mW/cm$^2$ et environ 150 mW/cm$^2$, les températures spectrales correspondantes de distribution de la lampe étant situées entre environ 2550° K et environ 3400° K, et l'épaisseur de la couche d'électrolyte étant égale à 25 mm.

10. Dispositif pour la mise en oeuvre du procédé selon l'une des revendications 1 à 9, qui comprend une alimentation en courant, une cathode, des moyens permettant de brancher l'élément à traiter en tant qu'anode, et des moyens pour recouvrir une surface à graver par l'électrolyte, caractérisé en ce qu'il comporte une lampe possédant une composante intense de lumière dans la zone du proche infrarouge pour l'irradiation de la surface à graver.

11. Dispositif selon la revendication 10, caractérisé en ce que la pièce à traiter (20) comporte de nombreuses zones à graver, qui sont limitées respectivement par deux voies conductrices réciproquement opposées (12, 13), et deux raccords (40, 41) pour appliquer les deux potentiels, et que chacune des voies conductrices (12, 13) est reliées par l'intermédiaire de liaisons (16, 17) à l'un des raccords (40, 41) de telle manière que les voies conductrices voisines en vis-à-vis (12, 13) ne sont raccordées en aucun cas au même raccord (40, 41).

FIG.1

FIG.2A

FIG.2B

A-A

FIG.3

- N-Si
- P-Si
- STANDARDABWEICHUNG (1σ)

BESTRAHLUNGSSTÄRKE [mW/cm²]

ÄTZTIEFE [nm]

FIG.4A

FIG.4B

FIG.4C

FIG.5

FIG.6A

FIG.6B

FIG.6C